# EUROPÄISCHE PATENTANMELDUNG

(11) **EP 4 574 322 A1**
(43) Veröffentlichungstag der Anmeldung: **25.06.2025**
(21) Anmeldenummer: 23218772.4
(22) Anmeldetag: 20.12.2023
(51) Int. Cl.: B23K 1/008, F27B 17/00, F27D 7/04, F27D 19/00, G05B 11/42, G05B 13/04, H01L 21/324, H01L 21/67

(54) **VORRICHTUNG UND VERFAHREN ZUR WÄRMEBEHANDLUNG VON BAUTEILEN**

(71) Anmelder: SmartTec GmbH, 63110 Rodgau (DE)
(72) Erfinder: Ateeq, Mohammed, 63110 Rodgau (DE)
(74) Vertreter: Stein, Erik

(57) **Zusammenfassung**

Die Erfindung betrifft ein Verfahren und eine Vorrichtung zur Wärmebehandlung von Bauteilen (12) in einer verschließbaren Wärmekammer (2), wobei die Bauteile (12) vertikal voneinander beabstandet in einer Lagervorrichtung (11) innerhalb der Wärmekammer (2) gelagert sind und von einem hinsichtlich seiner Temperatur und/oder seiner Menge einstellbaren Heißgasstrom umströmt werden, das Verfahren umfassend die in einer Steuereinheit durchgeführten Schritte:
(i) Einlesen von Messwerten für Temperaturen von mehreren in der Wärmekammer (2) örtlich verteilten Temperatursensoren (6) und optional der Menge des Heißgasstromes;
(ii) Vergleich der eingelesenen Messwerte mit vorgegebenen Sollwerten; und
(iii) Bereitstellung von Stellsignalen für die Einstellung der Temperatur und/oder der Menge des Heißgasstromes in Abhängigkeit des Vergleichs derart, dass ein vorgegebener zeitlicher Verlauf für die Sollwerte während der Wärmebehandlung eingehalten wird, wobei die Sollwerte eine sich bei mindestens einem der Bauteile (12) einstellende Soll-Bauteiltemperatur umfassen, wobei die sich einstellende Bauteiltemperatur durch ein in der Steuereinheit implementiertes Modell bestimmt wird.

## Beschreibung

### Gebiet der Erfindung

Die Erfindung betrifft ein Verfahren und eine Vorrichtung zur Wärmebehandlung von Bauteilen in einer verschließbaren Wärmekammer, in der die Bauteile vertikal voneinander beabstandet von einem einstellbaren Heißgasstrom umströmt werden.

### Hintergrund der Erfindung

In modernen industriellen Fertigungsprozessen ist es häufig erforderlich, die herzustellenden Produkte über eine gewisse Zeit auf eine vorbestimmte Temperatur zu erwärmen, beispielsweise als Zwischenschritt vor der Bearbeitung in einem weiteren Verfahrensschritt oder als Endbehandlung des fertigzustellenden Produktes. Typische Verfahrensschritte, die eine Wärmebehandlung erfordern, sind Lötvorgänge, Schmelzklebevorgänge und Aushärtungsvorgänge, beispielsweise von Produkten, die mit einer Lackschicht oder einer polymeren Schutzschicht überzogen sind.

Insbesondere in der Elektronikindustrie gibt es vielfältigen Bedarf an unterschiedlichen Wärmebehandlungsprozessen. Bei der Herstellung von gedruckten Leiterplatten (Printed Circuit Boards, PCB) beispielsweise gehören zu den üblichen Erwärmungsvorgängen Lötmittelaufschmelzvorgänge, bei denen Lötmittel, das als Paste auf die Leiterplatten zwischen den Anschlüssen der zu montierenden Schaltungskomponenten und den auf der Leiterplatte vorhandenen leitenden Verbindungen bereitgestellt wird, geschmolzen wird, um dazwischen elektrische Verbindungen herzustellen, sowie Kugelklebevorgänge zur Befestigung von auf Schaltungskomponenten gebildeten Lötkugeln.

Weitere wichtige Anwendungsfelder von Wärmebehandlungsprozessen in der Elektronikindustrie sind Aushärtungsvorgänge zur Vervollständigung der Verklebung und Verfestigung von Klebstoffen und Füllungen, die bei der Montage von Komponenten verwendet werden. So ist beispielsweise der Aushärtungsprozess zu einem integralen Bestandteil der Herstellung von Leiterplatten geworden. Er gewährleistet, dass das PCB-Material ordnungsgemäß ausgehärtet wird, was zu qualitativ hochwertigen, zuverlässigen und langlebigen Produkten führt.

Unter dem Begriff der Aushärtung wird in Bezug auf die Herstellung von Leiterplatten der Prozess der Verfestigung ursprünglich flüssiger oder viskoser Materialien durch Einwirkung von Wärme verstanden, beispielsweise auf Basis physikalischer Phänomene wie der Trocknung oder chemischer Vorgänge wie der Vernetzung von Molekülstrukturen oder Polymerisation.

Der Aushärtungsprozess ist ein kritischer Schritt bei der Herstellung von Leiterplatten, der die Qualität und Langlebigkeit der Produkte stark beeinflusst. Über die Zeit haben sich die Verfahren zur Aushärtung von Leiterplatten weiterentwickelt, ausgehend von einer simplen Trocknung in der Anfangsphase der Leiterplattenherstellung, über Techniken unter Einsatz von UV-Licht bis hin zu diversen thermischen Verfahren, die sich heutzutage durchgesetzt haben.

Beim thermischen Verfahren wird das Leiterplattenmaterial über einen bestimmten Zeitraum auf eine vorgegebene Temperatur erhitzt. Durch die Einwirkung der Wärme auf das auszuhärtende Material werden physikalisch-chemische Prozesse in Gang gesetzt, die dazu führen, dass das auszuhärtende Material seine Struktur verändert und dauerhaft fest wird. Das thermische Verfahren wird in sogenannten Öfen durchgeführt, bei denen die Leiterplatten in einer beheizten Wärmekammer der Wärme ausgesetzt werden. Es sind unterschiedliche Ofentypen zur Durchführung der Wärmebehandlung bekannt. Allen Typen ist gemein, dass sie einen eigenständigen Verfahrensschritt darstellen, der nach einem vorhergehenden Herstellschritt durchgeführt wird. Je nach Dauer der thermischen Behandlung im Verhältnis zur Dauer des Herstellschrittes kann die Wärmebehandlung einen limitierenden Faktor in der Taktung der gesamten Prozesskette darstellen.

Dies ist beispielsweise häufig der Fall bei dem klassischen, sogenannten horizontalen Aushärteofen, bei dem die Leiterplatten einzeln in den Aushärteofen eingeführt werden. Da der sequentielle Durchlauf durch eine baulich begrenzte Wärmekammer meist mehr Zeit in Anspruch nimmt als der vorherige Herstellschritt, der beispielsweise eine Beschichtung umfassen kann, kommt es bei diesem Ofentyp häufig zu Engpässen, die sich auf die gesamte Prozesskette auswirken. Der Produzent steht daher häufig vor der Wahl, entweder eine verringerte Produktivität durch Reduzierung der Taktzyklen in Kauf zu nehmen oder zusätzliche Investitionen zu tätigen, um einen entsprechend größeren Ofen mit dem erforderlichen Bauraum bereitzustellen.

In Bezug auf die Produktivitätsproblematik schafft eine andere Art von Ofen eine gewisse Abhilfe. Bei dem sogenannten vertikalen Inline-Aushärteofen handelt sich um einen Durchlaufofen, bei dem die Leiterplatten nicht nur horizontal durch die Wärmekammer transportiert werden, sondern auch vertikal. Typischerweise transportiert ein horizontales Förderband die beschichteten Leiterplatten in den Ofen, wo sie in einem ersten Abschnitt der Wärmekammer vertikal nach oben transportiert werden, anschließend horizontal an einen zweiten Abschnitt der Wärmekammer übergeben und in dem zweiten Abschnitt vertikal wieder nach unten transportiert werden. Im Vergleich zum horizontalen Aushärteofen ist die Produktionskapazität durch die Erweiterung der Wärmekammer in der Vertikalen bei vergleichbarem Flächenverbrauch deutlich erhöht.

Die modernste Art von industriellen Aushärteöfen stellen sogenannte Magazinöfen dar. Bei diesem Ofentyp werden die Leiterplatten nach dem vorhergehenden Herstellschritt zunächst in ein selbsttragendes Magazin überführt, und anschließend das Magazin mitsamt der Leiterplatten in den Magazinofen eingeschoben.

Um optimale Ergebnisse bei der Aushärtung zu erzielen, sind die Dauer der Heizzyklen und die jeweils einzustellenden Temperaturen in Abhängigkeit von dem auszuhärtenden Material zu wählen. Das Dokument US 2012/0223066 A1 beispielsweise offenbart einen Ofen zur thermischen Behandlung von Substraten, der eine Vielzahl an individuell regelbaren Heizzonen umfasst. Bei der Regelung kann zwischen zwei Arten umgeschaltet werden, bei denen jeweils unterschiedlich viele Regelzonen zu einer Einheit zusammengefasst werden. Bei Temperaturänderungen werden viele kleine Heizzonen individuell eingestellt, während bei konstanter Temperaturfahrweise größere Heizzonen zusammengeschaltet werden.

Das Dokument CN 216600263 U offenbart einen Ofen zum Aushärten von Leiterplatten, der eine Wärmekammer umfasst, in der Leiterplatten von einem Heißluftstrom umströmt werden. In der Wärmekammer sind mehrere Temperatursensoren angebracht, mittels derer die Temperatur an mehreren Stellen innerhalb der Wärmekammer erfasst werden kann.

Eine weitere Bauart eines Ofens zur Wärmebehandlung von elektronischen Bauteilen ist im Dokument US 2022/0189809 A1 beschrieben. Ein in den Ofen einzubringendes Gestell ist so konfiguriert, dass es eine Vielzahl von Substraten in einer gestapelten Weise tragen kann, wobei vertikale Abstände die Substrate voneinander trennen, um eine gute Zirkulation eines zur Erwärmung verwendeten heißen Gasstroms zu ermöglichen.

Obwohl die Technologieentwicklung zu Aushärteöfen in der Vergangenheit große Fortschritte gemacht hat, besteht noch Bedarf, die vorhandenen Technologien weiterzuentwickeln. Da Leiterplatten immer komplexer werden, unter anderem aufgrund von Mehrlagigkeit und dem Trend zu kleineren Bauteilen, ist es wichtig sicherzustellen, dass die Beschichtung vollständig aushärtet, um unerwünschte Effekte wie Delamination, Rissbildung oder sonstige Fehler zu verhindern, die die Leiterplatte unbrauchbar machen würden. Weiterhin besteht der Wunsch seitens der Herstellen, eine hohe Produktivität auf möglichst kleinem Bauraum zu verwirklichen. Dabei sollte die Produktion flexibel an sich ändernde Anforderungen anpassbar sein.

### Der Erfindung zugrundeliegende Aufgabe

Der Erfindung liegt die Aufgabe zugrunde, ein Verfahren und eine Vorrichtung zur Wärmebehandlung von Bauteilen bereitzustellen, bei denen eine vollständige Aushärtung in einem vorgegebenen Temperaturbereich gewährleistet ist. Der Erfindung liegt weiterhin die Aufgabe zugrunde, ein Verfahren und eine Vorrichtung bereitzustellen, bei denen auf möglichst kleiner Fläche eine möglichst hohe Produktivität erzielt wird. Der Erfindung liegt weiterhin die Aufgabe zugrunde, ein Verfahren und eine Vorrichtung bereitzustellen, die flexibel auf sich ändernde Anforderungen in der Produktion anpassbar sind, insbesondere im Hinblick auf die Art und Anzahl der zu bearbeitenden Bauteile.

### Erfindungsgemäße Lösung

Im Nachfolgenden ist, im Falle des Fehlens gegenteiliger Hinweise, jede Bezugnahme auf ein (auch durch unbestimmte und bestimmte Artikel), zwei oder eine andere Zahl von Gegenständen in der Weise zu verstehen, dass das Vorhandensein weiterer solcher Gegenstände nicht ausgeschlossen ist. Die Bezugszeichen in sämtlichen Ansprüchen haben keine einschränkende Wirkung, sondern sollen lediglich deren Lesbarkeit verbessern.

Die Lösung der gestellten Aufgabe gelingt durch ein Verfahren mit den Merkmalen des Anspruchs 1 sowie durch eine Vorrichtung mit den Merkmalen des Anspruchs 11.

Im Folgenden werden die Begriffe "haben", "aufweisen", "umfassen" oder "einschließen" oder beliebige grammatikalische Abweichungen davon in nicht-ausschließlicher Weise verwendet. Dementsprechend können sich diese Begriffe sowohl auf Situationen beziehen, in welchen neben dem durch diese Begriffe eingeführten Merkmal keine weiteren Merkmale vorhanden sind, oder auf Situationen, in welchen ein oder mehrere weitere Merkmale vorhanden sind. Beispielsweise kann sich der Ausdruck "A hat B", "A weist B auf", "A umfasst B" oder "A schließt B ein" sowohl auf die Situation beziehen, in welcher, abgesehen von B, kein weiteres Element in A vorhanden ist (d.h. auf eine Situation, in welcher A ausschließlich aus B besteht), als auch auf die Situation, in welcher, zusätzlich zu B, ein oder mehrere weitere Elemente in A vorhanden sind, beispielsweise Element C, Elemente C und D oder weitere Elemente.

Die Formulierung "und/oder" ist im Folgenden so zu verstehen, dass sämtliche Ausführungsformen umfasst sind, bei denen die mit "und/oder" verknüpften Merkmale jeweils einzeln oder gemeinsam vorhanden sind. Beispielsweise kann sich der Ausdruck "A und/oder B" sowohl auf die Situation beziehen, in welcher nur das Merkmal A oder nur das Merkmal B in einer Ausführungsform vorhanden ist, als auch auf die Situation, in welcher beide Merkmale A und B in derselben Ausführungsform vorhanden sind.

Weiterhin wird darauf hingewiesen, dass die Begriffe "mindestens ein" und "ein oder mehrere" sowie grammatikalische Abwandlungen dieser Begriffe oder ähnliche Begriffe, wenn diese in Zusammenhang mit einem oder mehreren Elementen oder Merkmalen verwendet werden und ausdrücken sollen, dass das Element oder Merkmal einfach oder mehrfach vorgesehen sein kann, in der Regel lediglich einmalig verwendet werden, beispielsweise bei der erstmaligen Einführung des Merkmals oder Elementes. Bei einer nachfolgenden erneuten Erwähnung des Merkmals oder Elementes wird der entsprechende Begriff "mindestens ein" oder "ein oder mehrere" in der Regel nicht mehr verwendet, ohne Einschränkung der Möglichkeit, dass das Merkmal oder Element einfach oder mehrfach vorgesehen sein kann.

Weiterhin werden im Folgenden die Begriffe "vorzugsweise", "insbesondere", "beispielsweise" oder ähnliche Begriffe in Verbindung mit optionalen Merkmalen verwendet, ohne dass alternative Ausführungsformen hierdurch beschränkt werden. So sind Merkmale, welche durch diese Begriffe eingeleitet werden, optionale Merkmale, und es ist nicht beabsichtigt, durch diese Merkmale den Schutzumfang der Ansprüche und insbesondere der unabhängigen Ansprüche einzuschränken. So kann die Erfindung auch unter Verwendung anderer Ausgestaltungen durchgeführt werden. In ähnlicher Weise werden Merkmale, welche durch "in einer Ausführungsform der Erfindung" oder durch "in einem Ausführungsbeispiel der Erfindung" eingeleitet werden, als optionale Merkmale verstanden, ohne dass hierdurch alternative Ausgestaltungen oder der Schutzumfang der unabhängigen Ansprüche eingeschränkt werden soll. Weiterhin sollen durch diese einleitenden Ausdrücke sämtliche Möglichkeiten, die hierdurch eingeleiteten Merkmale mit anderen Merkmalen zu kombinieren, seien es optionale oder nicht-optionale Merkmale, unangetastet bleiben.

Bei dem erfindungsgemäßen Verfahren zur Wärmebehandlung von Bauteilen sind in einer verschließbaren Wärmekammer die Bauteile vertikal voneinander beabstandet in einer Lagervorrichtung innerhalb der Wärmekammer gelagert und werden von einem hinsichtlich seiner Temperatur und/oder seiner Menge einstellbaren Heißgasstrom umströmt. Das Verfahren umfasst weiterhin die folgenden Schritte, die in einer Steuereinheit durchgeführt werden:
(i) Einlesen von Messwerten für Temperaturen von mehreren in der Wärmekammer örtlich verteilten Temperatursensoren und optional der Menge des Heißgasstromes;
(ii) Vergleich der eingelesenen Messwerte mit vorgegebenen Sollwerten; und
(iii) Bereitstellung von Stellsignalen für die Einstellung der Temperatur und/oder der Menge des Heißgasstromes in Abhängigkeit des Vergleichs derart, dass ein vorgegebener zeitlicher Verlauf für die Sollwerte während der Wärmebehandlung eingehalten wird.

Die Sollwerte umfassen erfindungsgemäß eine sich bei mindestens einem der Bauteile einstellende Soll-Bauteiltemperatur, wobei die sich einstellende Bauteiltemperatur durch ein in der Steuereinheit implementiertes prädiktives Modell bestimmt wird.

Eine erfindungsgemäße Vorrichtung zur Wärmebehandlung von Bauteilen umfasst eine verschließbare Wärmekammer, die mehrere örtlich verteilte Temperatursensoren aufweist, Mittel zur Erzeugung eines hinsichtlich seiner Temperatur und/oder seiner Menge einstellbaren Heißgasstromes, sowie eine Steuereinheit, die so eingerichtet ist, dass sie die Schritte des erfindungsgemäßen Verfahrens ausführt.

Weiterhin wird die gestellte Aufgabe gelöst durch ein Computerprogrammprodukt, umfassend Befehle, die bei der Ausführung des Programms durch die Steuereinheit der erfindungsgemäßen Vorrichtung diese veranlassen, das erfindungsgemäße Verfahren auszuführen. Ein weiterer Gegenstand der Erfindung ist ein computerlesbares Medium, auf dem das Computerprogrammprodukt gespeichert ist.

Durch das erfindungsgemäße Verfahren und die erfindungsgemäße Vorrichtung werden mehrere Vorteile erzielt: Es hat sich gezeigt, dass durch die modellbasierte Bestimmung der sich einstellenden Bauteiltemperatur eine präzisere Regelung des Prozesses der Wärmebehandlung realisierbar ist, als dies bei herkömmlichen Verfahren der Fall ist. Dadurch lassen sich zu hohe oder zu niedrige Temperaturen vermeiden, die beispielsweise bei einem Aushärteprozess für Leiterplatten im einen Fall zu unvollständiger Aushärtung führen würden, im anderen Fall eine Degradation bis hin zur Zerstörung von elektronischen Komponenten oder einer Delamination von Leiterplattenschichten nach sich ziehen könnten. Weiterhin gelingt es durch das erfindungsgemäße Verfahren und die erfindungsgemäße Vorrichtung, die Dauer des Prozesses zur Wärmebehandlung bauteilspezifisch zu optimieren, was die Produktivität steigert. Schließlich eignen sich das erfindungsgemäße Verfahren und die erfindungsgemäße Vorrichtung für die Wärmebehandlung vieler verschiedener Bauteile mit geringer Stückzahl ebenso wie für die Wärmebehandlung einiger weniger verschiedener Bauteile in großer Stückzahl, sodass sie flexibel an sich ändernde Anforderungen in der Produktion anpassbar sind

### Bevorzugte Ausgestaltungen der Erfindung

Vorteilhafte Aus- und Weiterbildungen, welche einzeln oder in Kombination miteinander eingesetzt werden können, sind Gegenstand der abhängigen Ansprüche und der nachfolgenden Beschreibung.

Unter dem Begriff "Wärmebehandlung" wird verstanden, dass die zu behandelnden Bauteile über eine gewisse Zeit einer gewissen Temperatur ausgesetzt werden. Die Zeitspannen und Temperaturbereiche können auf den jeweiligen Anwendungsfall angepasst sein. In einer Ausführungsform umfasst eine Wärmebehandlung mehrere aneinander angrenzende Zeiträume, in denen unterschiedliche Temperaturbereiche eingestellt werden. Die Temperaturbereiche pro Zeitraum können konstant gehaltene Temperaturen oder variable Temperaturen umfassen, beispielsweise sogenannte Temperaturrampen, bei denen die Temperatur graduell erhöht oder verringert wird. Die Temperaturverläufe während des Übergangs von einer Temperatur zu einer anderen Temperatur können linear oder nichtlinear gestaltet sein.

In einer Variante beginnt die Wärmebehandlung mit einer Vorwärmperiode, während der die Wärmekammer von einer Starttemperatur bis auf eine Vorwärmtemperatur aufgewärmt wird. An die Vorwärmperiode kann sich eine Aufheizperiode anschließen, während der die Wärmekammer von der Vorwärmtemperatur bis auf eine Aufheiztemperatur aufgewärmt wird. An die Aufheizperiode kann sich eine Halteperiode anschließen, während der die Temperatur konstant auf der Aufheiztemperatur gehalten wird. An die Halteperiode kann sich eine Abkühlperiode anschließen, während der die Temperatur von der Aufheiztemperatur bis zu einer Endtemperatur abgekühlt wird.

Das erfindungsgemäße Verfahren ist grundsätzlich für sämtliche Bauteile geeignet, die in einer Lagervorrichtung lagerbar einer Wärmebehandlung in einer Wärmekammer unterzogen werden können. Der Begriff "Bauteil" ist hinsichtlich seiner Merkmale und Eigenschaften nicht einschränkend zu verstehen. Synonym kann auch der Begriff "Gegenstand" verwendet werden. In einer Ausführungsform sind die Bauteile flächige Bauteile, bevorzugt elektronische Bauteile, insbesondere Leiterplatten oder Platinen.

Unter einem "flächigen Bauteil" wird ein Gegenstand verstanden, dessen geometrische Ausdehnung in der horizontalen Ebene größer ist als seine Ausdehnung in der zur horizontalen Ebene orthogonalen Vertikalen. Ohne Beschränkung der allgemeinen Definition ist beispielsweise ein Quader mit Kantenlängen von 10, 5 und 2 Längeneinheiten als "flächig" im Sinne der Erfindung anzusehen, wohingegen ein Würfel mit gleicher Kantenlänge in alle Raumrichtungen nicht als "flächig" anzusehen wäre.

Die Lagervorrichtung ist geeignet, aufzunehmende Bauteile so zu lagern, dass sie im gelagerten Zustand in vertikaler Richtung einen Abstand aufweisen. Die Lagervorrichtung kann fest mit der Wärmekammer verbunden sein. Ein Beispiel für eine derartige Ausführungsform sind fest im Innenraum der Wärmekammer verbundene Ständer oder Ablagefächer, in denen die Bauteile gelagert werden können. Die Lagervorrichtung kann aber auch ein separates bewegliches Element sein. In einer Ausführungsform ist die Lagervorrichtung ein in die Wärmekammer einbringbares und aus dieser entnehmbares Magazin. Vorzugsweise ist die bewegliche Lagervorrichtung mit Mitteln versehen, die einen einfachen Transport in die und aus der Wärmekammer ermöglichen, beispielsweise Rollen oder Kufen an ihrem unteren Ende. Die Lagervorrichtung kann Ablagefächer, vorzugsweise Schubfächer, aufweisen, in denen die Bauteile aufgenommen werden können. Die vertikalen Abstände zwischen den Ablagefächern kann fest vorgegeben oder variabel sein. Bewegliche Lagervorrichtungen, insbesondere Magazine, haben den Vorteil, dass sie individuell auf die Bedürfnisse der jeweiligen Wärmebehandlung von Bauteilen angepasst werden können. Ein weiterer Vorteil von beweglichen Lagervorrichtungen ist, dass die Bauteile unabhängig von anderen Prozessschritten für die Wärmebehandlung vorbereitet werden können, sodass eine Optimierung der gesamten Prozesskette ermöglicht und potenzielle Wartezeiten verringert oder gänzlich vermieden werden können.

Die Wärmebehandlung erfolgt erfindungsgemäß durch ein Umströmen der Bauteile mit einem Heißgasstrom. Der Wärmeübergang erfolgt also überwiegend konvektiv, wobei auch Strahlungswärme zur Erwärmung der Bauteile beitragen kann, beispielsweise wenn kühle Bauteile in eine bereits aufgeheizte Wärmekammer eingebracht werden. Die Art des zur Wärmebehandlung eingesetzten Gases kann auf die Anforderungen hinsichtlich Material der Bauteile oder des abzudeckenden Temperaturbereichs gewählt werden. Das Gas kann eine Reinsubstanz oder eine Mischung aus unterschiedlichen Substanzen sein. In einer Ausführungsform handelt es sich bei dem Gas um Luft, sodass der Heißgasstrom auch als Heißluftstrom bezeichnet werden kann. In einer anderen Ausführungsform enthält das Gas keinen Sauerstoff, um beispielsweise potenziellen Problemen durch Oxidation des Bauteilmaterials mit dem Sauerstoff vorzubeugen. Ein hierfür geeignetes Gas ist beispielsweise Stickstoff.

Der Heißgasstrom ist hinsichtlich seiner Temperatur, seiner Menge oder sowohl seiner Temperatur und seiner Menge einstellbar. Mittel zur Beeinflussung der Temperatur und der Menge eines Gasstromes sind im Stand der Technik bekannt. Zur Einstellung der Temperatur wird der Gasstrom vorzugsweise um oder durch ein Heizelement geleitet. Ein entsprechendes Heizelement kann auf unterschiedliche Arten beheizt werden, beispielsweise durch Verbrennung eines festen, flüssigen oder gasförmigen Brennstoffes wie Wasserstoff, Erdgas oder ein anderes brennbares Gas, oder durch elektrische Energie. Vorzugsweise ist das Heizelement elektrisch beheizt. Der Mengenstrom des Heißgases kann beispielsweise dadurch variiert werden, dass eine Gasfördereinrichtung den Gasstrom in Bewegung versetzt. Geeignete Gasfördereinrichtungen sind beispielsweise Gebläse oder Ventilatoren. Die Mittel zur Einstellung der Temperatur und/oder des Mengenstromes des Heißgases können an unterschiedlichen Orten in oder an der Vorrichtung angebracht sein, beispielsweise in der Wärmekammer oder außerhalb der Wärmekammer, z.B. in einem Strömungskanal, der durch Öffnungen mit der Wärmekammer verbunden ist. Vorzugsweise sind die Mittel außerhalb der Wärmekammer angeordnet.

In einer Ausführungsform sind mehrere Heizelemente und/oder mehrere Gasfördereinrichtungen vorhanden, die an unterschiedlichen Positionen an oder in der Vorrichtung angeordnet sind, beispielsweise auf zwei gegenüberliegenden Seiten der Wärmekammer. Durch eine solche Anordnung lässt sich ein einfaches Umschalten der Strömungsrichtung des Heißgasstromes realisieren, was hinsichtlich der Prozessführung der Wärmebehandlung für einige Anwendungsfälle vorteilhaft sein kann.

Die Wärmebehandlung wird in einer verschließbaren Wärmekammer durchgeführt. Die Wärmekammer kann jede Gestalt aufweisen, die für das Einbringen der Bauteile und die Umströmung der Bauteile mit einem Heißgas geeignet ist.

In einer Ausführungsform umfasst die Wärmekammer einen Boden, eine Decke, zwei einander gegenüberliegende Seitenwände, eine Rückseite und eine Vorderseite. Die Vorderseite, die Rückseite oder die Vorderseite und die Rückseite können eine verschließbare Öffnung aufweisen, durch die die zu behandelnden Bauteile in die Wärmekammer eingebracht und/oder aus dieser entnommen werden können. Die Grundfläche, also die Querschnittsform des Bodens und der Decke kann unterschiedlich gestaltet sein, beispielsweise rechteckig, quadratisch oder mehreckig mit mehr als vier Ecken, vorzugsweise ist sie rechteckig oder quadratisch. Die Form der Seitenwände, der Rückseite und/oder der Vorderseite kann gerade oder gekrümmt sein, vorzugsweise ist sie gerade.

In einer Ausführungsform, bei der die Lagervorrichtung fest mit der Wärmekammer verbunden ist, können die Seitenwände beispielsweise Aufnahmevorrichtungen wie Schienen aufweisen, in die Ablagefächer mit darin befindlichen zu behandelnden Bauteilen eingeschoben werden können.

Der Boden der Wärmekammer kann eine Fördereinrichtung aufweisen, über die eine bewegliche Lagervorrichtung wie ein Magazin in die Wärmekammer eingebracht und aus dieser entfernt werden kann. Eine zu diesem Zweck geeignete Fördereinrichtung kann beispielsweise Rollen oder ein Förderband umfassen.

Die Decke der Wärmekammer kann zusätzlich oder alternativ zum Boden eine Fördereinrichtung aufweisen, über die eine bewegliche Lagervorrichtung wie ein Magazin in die Wärmekammer eingebracht und aus dieser entfernt werden kann. Eine zu diesem Zweck geeignete Fördereinrichtung kann beispielsweise eine Einrichtung umfassen, die eine Schiene und eine Aufnahmevorrichtung aufweist, sodass die Lagervorrichtung in die Aufnahmevorrichtung eingehängt und anschließend entlang der Schiene in die Wärmekammer transportiert werden kann.

In einer Ausführungsform weist die Wärmekammer Eintrittsöffnungen und Austrittsöffnungen für das Heißgas auf. In einer Variante dieser Ausführungsform befinden sich die Eintrittsöffnungen in einer Seitenwand und die Austrittsöffnungen in einer anderen Seitenwand. Vorzugsweise befinden sich die Eintrittsöffnungen und die Austrittsöffnungen in einander gegenüberliegenden Seitenwänden. Bei dieser Ausgestaltung lässt sich auf einfach Weise eine im Wesentlichen horizontal verlaufende Strömung des Heißgases realisieren, die hinsichtlich einer möglichst homogenen Umströmung der vertikal beabstandeten Bauteile von Vorteil ist.

In einer vorteilhaften Weiterbildung sind die Eintrittsöffnungen und/oder die Austrittsöffnungen gleichmäßig über die jeweilige Seitenwand verteilt angeordnet. Vorzugsweise ist eine Vielzahl an Eintrittsöffnungen und/oder Austrittsöffnungen in der jeweiligen Seitenwand gleichmäßig verteilt angeordnet. Der Begriff "gleichmäßig" ist dabei so zu verstehen, dass pro Flächenabschnitt der Seitenwand die gesamte Öffnungsfläche bezogen auf die Gesamtfläche des Flächenabschnitts um nicht mehr als 30%, bevorzugt nicht mehr als 20%, besonders bevorzugt nicht mehr als 10%, insbesondere nicht mehr als 5% von dem entsprechenden Wert eines anderen Flächenabschnittes abweicht. Zur Berechnung der entsprechenden Werte können beispielsweise obere/untere Hälfte, rechte/linke Hälfte, entsprechende Drittel, Quadranten oder andere Aufteilungen herangezogen werden. Unter der "gesamten Öffnungsfläche" ist dabei die Summe der einzelnen Querschnittsflächen aller Öffnungen in dem entsprechenden Flächenabschnitt zu verstehen.

Die Eintrittsöffnungen und/oder die Austrittsöffnungen können beliebige Formen aufweisen, beispielsweise eine runde, elliptische, eckige Form oder Kombinationen daraus. Es können auch unterschiedliche Formen beispielsweise in einer Seitenwand kombiniert werden, z.B. eine alternierende Folge von einen oder mehreren schlitzförmigen Öffnungen mit einer Reihe von punktförmigen Öffnungen.

In einer Ausführungsform ist die Wärmekammer in einem Gehäuse angeordnet, das die Wärmekammer umhüllt. Vorzugsweise sind in demselben Gehäuse auch Mittel zur Erzeugung des Heißgasstromes angeordnet, insbesondere eine Gasfördereinrichtung und ein Heizelement. In einer Variante der Ausführungsform mit Gehäuse ist zwischen den äußeren Oberflächen der Seitenwände sowie der Decke der Wärmekammer und den jeweils benachbarten inneren Oberflächen des Gehäuses ein Abstand vorhanden, wodurch sich ein Strömungsraum für das Heißgas um die Wärmekammer ergibt. In einer weiteren Variante ist zwischen den äußeren Oberflächen der Seitenwände sowie des Bodens der Wärmekammer und den jeweils benachbarten inneren Oberflächen des Gehäuses ein Abstand vorhanden, wodurch sich ein Strömungsraum für das Heißgas um die Wärmekammer ergibt. In einer weiteren Variante ist zwischen den äußeren Oberflächen der Seitenwände, des Bodens sowie der Decke der Wärmekammer und den jeweils benachbarten inneren Oberflächen des Gehäuses ein Abstand vorhanden, wodurch sich ein Strömungsraum für das Heißgas um die Wärmekammer ergibt.

In der Wärmekammer sind mehrere Temperatursensoren örtlich verteilt angeordnet. In einer Ausführungsform sind mehrere Temperatursensoren an einer Fläche innerhalb der Wärmekammer angeordnet, beispielsweise an einer Seitenwand, der Rückseite, der Vorderseite, dem Boden oder der Decke. In einer anderen Ausführungsform sind mehrere Temperatursensoren an unterschiedlichen Flächen innerhalb der Wärmekammer angeordnet, beispielsweise auf gegenüberliegenden Seitenwänden, dem Boden und/oder der Decke. Vorzugsweise sind die Temperatursensoren an solchen Stellen angeordnet, an denen sich charakteristische Werte für den Temperaturverlauf innerhalb der im Betrieb vom Heißgas durchströmten Wärmekammer einstellen. Bevorzugte Stellen sind die Orte, an denen das Heißgas einströmt und an denen das Heißgas ausströmt. In einer Ausführungsform sind zumindest einige der Temperatursensoren in räumlicher Nähe zu den Eintrittsöffnungen und einige der Temperatursensoren in räumlicher Nähe zu den Austrittsöffnungen angeordnet. Weiterhin ist bevorzugt, dass sich die örtliche Verteilung auf alle Raumrichtungen bezieht und beispielsweise auch am Boden und an der Decke Temperatursensoren angeordnet sind.

In einer Ausgestaltung, bei der die Eintrittsöffnungen und die Austrittsöffnungen jeweils in Seitenwänden angeordnet sind, sind jeweils mindestens drei Temperatursensoren an oder in der entsprechenden Seitenwand angebracht, wobei mindestens ein Temperatursensor im unteren Drittel, mindestens ein Temperatursensor im mittleren Drittel und mindestens ein Temperatursensor im oberen Drittel jeder Seitenwand angeordnet ist. Vorzugsweise sind die Temperatursensoren bei dieser Ausgestaltung in horizontaler Richtung jeweils im mittleren Drittel der betreffenden Seitenwand angeordnet. Es hat sich gezeigt, dass durch die vertikal verteilte Anordnung an den Seitenwänden mit Eintritts- und Austrittsöffnungen eine hinreichend genaue Abbildung der Temperaturverteilung innerhalb der Wärmekammer ermöglicht.

In einer weiteren Ausgestaltung sind auf der Seite der Eintrittsöffnungen und/oder auf der Seite der Austrittsöffnungen jeweils mehr als drei Temperatursensoren an oder in der jeweiligen Seitenwand gleichmäßig verteilt angeordnet, beispielsweise in Form eines geometrischen Gittermusters.

Die Temperatursensoren können mit bekannten konstruktiven Maßnahmen in der Wärmekammer angeordnet sein. In einer Ausgestaltung sind die Temperatursensoren auf der inneren Oberfläche einer Wand oder mehreren Wänden der Wärmekammer angebracht. In einer weiteren Ausgestaltung sind die Temperatursensoren in die Oberfläche einer Wand oder mehreren Wänden der Wärmekammer integriert. In einer weiteren Ausgestaltung sind die Temperatursensoren in einer oder mehreren der Eintrittsöffnungen und/oder Austrittsöffnungen angeordnet. Es hat sich gezeigt, dass eine Anordnung in einer Öffnung den Vorteil aufweist, dass die Messung der Temperatur weniger von Strömungseffekten des Heißgasstromes beeinflusst wird und somit einen genaueren Wert der in der Wärmekammer herrschenden Temperatur ermittelt.

Die Art und Anzahl der eingesetzten Temperatursensoren kann auf den jeweiligen Anwendungsfall angepasst werden und richtet sich beispielsweise nach der Größe und Gestalt der Wärmekammer. Geeignete Temperatursensoren sind im Stand der Technik bekannt und kommerziell erhältlich, beispielsweise Thermoelemente gemäß der Norm DIN EN 60584-1:2014-07 (IEC 60584-1:2013).

In einer Ausgestaltung der Erfindung ist die Vorrichtung modular aufgebaut, wodurch sie sich flexibel an die jeweiligen Bedürfnisse der konkret zu realisierenden Wärmebehandlung anpassen lässt. Insbesondere sind Erweiterungen oder Anlagenänderungen mit geringem Aufwand möglich.

In einer Ausführungsform ist die Vorrichtung modular aufgebaut und weist mindestens ein Heizmodul und ein Trennmodul auf. Das Heizmodul umfasst den Innenraum der Wärmekammer, die darin angeordneten Temperatursensoren sowie die Mittel zur Erzeugung des Heißgasstromes, wobei der Innenraum der Wärmekammer zumindest in eine Raumrichtung offen ist. Das Trennmodul umfasst einen Rahmen mit einer Durchgangsöffnung und ein in dem Rahmen beweglich gelagertes Verschlusselement, das im offenen Zustand die Durchgangsöffnung freigibt und im geschlossenen Zustand die Durchgangsöffnung vollständig verschließt. Das Trennmodul ist derart mit der offenen Seite des Heizmoduls verbunden, dass die Durchgangsöffnung des Trennmoduls die verschließbare Öffnung der Wärmekammer bildet.

In einer weiteren Ausführungsform ist die Vorrichtung modular aufgebaut und weist mindestens ein erstes Heizmodul, ein zweites Heizmodul und zwei Trennmodule auf. Die beiden Heizmodule umfassen jeweils den Innenraum der Wärmekammer und die darin angeordneten Temperatursensoren. Mindestens eines der Heizmodule umfasst die Mittel zur Erzeugung des Heißgasstromes. Der Innenraum der Wärmekammer des ersten Heizmoduls ist zumindest in eine Raumrichtung offen, und der Innenraum der Wärmekammer des zweiten Heizmoduls ist in zwei Raumrichtungen offen. Die Trennmodule umfassen einen Rahmen mit einer Durchgangsöffnung und ein in dem Rahmen beweglich gelagertes Verschlusselement, das im offenen Zustand die Durchgangsöffnung freigibt und im geschlossenen Zustand die Durchgangsöffnung vollständig verschließt. Ein Trennmodul ist derart mit der offenen Seite des ersten Heizmoduls und einer offenen Seite des zweiten Heizmoduls verbunden, dass im offenen Zustand der Durchgangsöffnung eine gemeinsame Wärmekammer und im geschlossenen Zustand zwei separate Wärmekammern vorliegen. Das andere Trennmodul ist derart mit der anderen offenen Seite des zweiten Heizmoduls verbunden, dass die Durchgangsöffnung des Trennmoduls die verschließbare Öffnung der Wärmekammer bildet.

Zur Durchführung des Verfahrens werden in einer Steuereinheit mehrere Schritte durchgeführt. Die Steuereinheit ist vorzugsweise eine Datenverarbeitungseinrichtung, die mit geeigneten Mitteln zum Einlesen und Ausgeben von Daten, zur Berechnung und zur Speicherung ausgestattet ist. Die Schritte des Verfahrens und die Mittel der Steuereinheit können als Softwarekomponenten, Hardwarekomponenten oder Kombinationen aus Hardware- und Softwarekomponenten realisiert sein.

Die Steuereinheit kann lokal in der Nähe der Wärmekammer vorhanden sein, beispielsweise an oder in einem Gehäuse, das die Wärmekammer umfasst, beispielsweise als Standalone-Anwendung der erfindungsgemäßen Vorrichtung ohne Ankopplung an andere Anlagen oder andere Datenverarbeitungseinrichtungen. Die Steuereinheit kann auch Teil eines weitergehenden Automatisierungssystems sein, beispielsweise als Baustein einer Speicherprogrammierbaren Steuerung (SPS) oder eines Prozessleitsystems (PLS), z.B. als ein Teil einer Fabrikautomatisierung. Die Steuereinheit kann als zentrales System oder als dezentrales System verteilt auf mehrere Komponenten, die miteinander im Datenaustausch stehen, realisiert sein.

Im ersten Schritt des Verfahrens werden Messwerte für Temperaturen von mehreren in der Wärmekammer örtlich verteilten Temperatursensoren und optional Messwerte der Menge des Heißgasstromes eingelesen. Mittel zum Einlesen von Messwerten können sämtliche Kommunikationsmittel umfassen, über die Datensignale von einer Messeinrichtung zur Steuereinheit übertragen werden können. Dabei kann es sich um drahtgebundene Kommunikationsmittel, drahtlose Kommunikationsmittel oder Kombinationen daraus handeln. Die Auswahl der jeweiligen Mittel richtet sich nach den Erfordernissen der Anwendung. Geeignete Mittel zum Einlesen der Messwerte sind im Stand der Technik bekannt.

Im zweiten Schritt des Verfahrens werden die eingelesenen Messwerte mit vorgegebenen Sollwerten verglichen. Die Steuereinheit weist dazu Mittel zum Vergleichen auf. Bei den Mitteln zum Vergleichen kann es sich um eine Recheneinheit eines Computers oder Mikrocontrollers handeln, in der Rechenoperationen und Vergleichsoperationen durchgeführt werden können.

Die Sollwerte können der Steuereinheit auf unterschiedliche Weise zur Verfügung gestellt werden. In einer ersten Variante werden die Sollwerte eingelesen. Die Sollwerte können dabei einzelne Werte oder ein Wertebereich sein. Das Einlesen erfolgt vorzugsweise über Mittel zum Einlesen. In einer Ausgestaltung umfassen die Mittel zum Einlesen Eingabemittel, über die eine Bedienperson einen Wert oder einen Wertebereich eingeben kann, beispielsweise eine Tastatur, ein Bedienpanel, ein beschreibbares Display oder ein Mikrofon zur Eingabe von Sprachbefehlen. Das Einlesen der Sollwerte kann auch dadurch erfolgen, dass die Sollwerte in einer anderen Anwendung bereitgestellt und über eine Kommunikationsschnittstelle an die Steuereinheit übermittelt werden, beispielsweise in Anwendungen, bei denen die Steuereinheit Teil eines weitergehenden Automatisierungssystems ist.

In einer weiteren Ausgestaltung wird zunächst ein Identifikationsmerkmal für die zu behandelnden Bauteile oder für eine Lagervorrichtung, die zu behandelnde Bauteile beinhaltet, von einer Eingabeeinheit eingelesen, und danach auf Basis des Identifikationsmerkmals die Sollwerte aus einer Produktdatenbank ausgelesen. Das Identifikationsmerkmal kann beispielsweise ein Name oder eine andere identifizierende Bezeichnung des zu behandelnden Bauteils oder der Lagervorrichtung sein. Das Identifikationsmerkmal kann beispielsweise über Mittel zum Einlesen eingelesen werden. Der Einlesevorgang des Identifikationsmerkmals kann auch dadurch erfolgen, dass eine Auswahl an Identifikationsmerkmalen bereitgestellt wird, zum Beispiel als Liste, und eine Bedienperson ein Identifikationsmerkmal aus der Auswahl auswählt. Die Produktdatenbank, aus der auf Basis des Identifikationsmerkmals die Sollwerte ausgelesen werden kann, kann ein Teil der Steuereinheit sein oder eine separate Datenbank, die über eine Kommunikationsschnittstelle mit der Steuereinheit verbunden ist.

Im dritten Schritt des Verfahrens werden in Abhängigkeit des Vergleichs aus dem vorherigen Schritt Stellsignale für die Einstellung der Temperatur und/oder der Menge des Heißgasstromes bereitgestellt, sodass ein vorgegebener zeitlicher Verlauf für die Sollwerte während der Wärmebehandlung eingehalten wird.

Die Art der Stellsignale richtet sich nach den zur Erzeugung des Heißgasstromes eingesetzten Komponenten. Beispielsweise sind bei einer Gasfördereinrichtung die Leistung eines Gebläses oder die Drehzahl eines Ventilators geeignete Stellgrößen. Bei einem Heizelement zur Aufheizung des Heißgasstromes ist beispielsweise die Heizleistung eine geeignete Stellgröße.

In einer Ausführungsform erfolgt die Bereitstellung der Stellsignale in Abhängigkeit des Vergleichs aus dem vorherigen Schritt dadurch, dass in einem Regler auf Basis des Vergleichs zwischen Sollwerten und Istwerten, die berechnete Größe oder die ermittelten Messwerte umfassen können, durch einen vorgegebenen Regelungsalgorithmus Stellsignale berechnet werden. Der Regelungsalgorithmus kann auf die jeweiligen Anforderungen des konkreten Anwendungsfalles angepasst sein, entsprechende Vorgehensweisen zum Entwurf und zur Implementierung eines Regelungsalgorithmus sind bekannt (https://de.wikipedia.org/wiki/Regelungstechnik#Regelkreisentwurf). Es hat sich gezeigt, dass Fuzzy-Regler und Neuro-Fuzzy-Regler besonders geeignet sind zur Durchführung des Verfahrens zur Wärmebehandlung.

Das Bereitstellen der Stellsignale erfolgt weiterhin vorzugsweise über Mittel zur Ausgabe von Datensignalen. Mittel zur Ausgabe von Datensignalen können sämtliche Kommunikationsmittel umfassen, über die Datensignale von der Steuereinheit an Komponenten wie Gasfördereinrichtung oder Heizelement übertragen werden können. Dabei kann es sich um drahtgebundene Kommunikationsmittel, drahtlose Kommunikationsmittel oder Kombinationen daraus handeln. Die Auswahl der jeweiligen Mittel richtet sich nach den Erfordernissen der Anwendung. Geeignete Mittel zur Ausgabe von Datensignalen sind im Stand der Technik bekannt.

Die Sollwerte umfassen eine sich bei mindestens einem der Bauteile einstellende Soll-Bauteiltemperatur. Unter dem Begriff "Bauteiltemperatur" wird eine Temperatur verstanden, die das Bauteil in seinem Inneren oder an seiner Oberfläche aufweist. Im Falle einer Temperatur an der Oberfläche des Bauteils wird im Folgenden auch synonym der Begriff der "Oberflächentemperatur" des Bauteils verwendet.

Unter dem Begriff "sich einstellende Bauteiltemperatur" ist eine Temperatur im oder am Bauteil zu verstehen, die sich aufgrund der Einwirkung der Wärmebehandlung durch den Heißgasstrom im oder am Bauteil einstellt.

In einer Ausführungsform umfassen die Sollwerte sich einstellende Soll-Bauteiltemperaturen von mindestens zwei unterschiedlichen Bauteilen, von denen eines in der oberen Hälfte der Lagervorrichtung und das andere in der unteren Hälfte der Lagervorrichtung gelagert ist. In einer weiteren Ausführungsform umfassen die Sollwerte sich einstellende Soll-Bauteiltemperaturen von mindestens drei unterschiedlichen Bauteilen, von denen eines im oberen Drittel der Lagervorrichtung, eines im mittleren Drittel der Lagervorrichtung und eines im unteren Drittel der Lagervorrichtung gelagert ist. In einer weiteren Ausführungsform umfassen die Sollwerte sich einstellende Soll-Bauteiltemperaturen von mindestens vier unterschiedlichen Bauteilen, von denen eines im obersten Viertel der Lagervorrichtung, eines im oberen mittleren Viertel der Lagervorrichtung, eines im unteren mittleren Viertel der Lagervorrichtung und eines im untersten Viertel der Lagervorrichtung gelagert ist.

In einer weiteren Ausführungsform umfassen die Sollwerte sich einstellende Soll-Bauteiltemperaturen von mehreren in der Lagervorrichtung gelagerten Bauteilen, wobei der vertikale Abstand zwischen zwei Bauteilen, deren sich einstellenden Bauteiltemperaturen als Sollwerte verwendet werden, höchstens fünf, bevorzugt höchstens vier, besonders bevorzugt höchstens drei, ganz besonders bevorzugt höchstens zwei, insbesondere höchstens einem Bauteil entspricht.

In einer weiteren Ausführungsform umfassen die Sollwerte sich einstellende Soll-Bauteiltemperaturen von mindestens 20 Prozent, bevorzugt mindestens 50 Prozent, besonders bevorzugt mindestens 75 Prozent, insbesondere 100 Prozent aller in der Lagervorrichtung gelagerten Bauteile.

In einer Ausführungsform umfassen die Sollwerte mindestens zwei sich bei demselben Bauteil einstellende Soll-Bauteiltemperaturen, wobei die Orte, an denen sich die Bauteiltemperaturen einstellen, in Strömungsrichtung des Heißgasstromes einen Abstand aufweisen. In einer weiteren Ausführungsform umfassen die Sollwerte mindestens drei, mindestens vier oder mindestens fünf sich bei demselben Bauteil einstellende Soll-Bauteiltemperaturen, wobei die Orte, an denen sich die Bauteiltemperaturen einstellen, in Strömungsrichtung des Heißgasstromes einen Abstand aufweisen.

In einer Ausführungsform umfassen die Sollwerte mindestens eine sich bei einem Bauteil einstellende Soll-Bauteiltemperatur, die für das betreffende Bauteil charakteristisch ist. Unter "charakteristisch" ist in diesem Zusammenhang zu verstehen, dass eine Wärmebehandlung an dem Ort, an dem sich die Bauteiltemperatur einstellt, einen Effekt hat, der für die Qualität der Wärmebehandlung wichtig ist. Dabei kann es sich beispielsweise um einen Ort auf dem Bauteil handeln, an dem eine temperatursensible elektronische Komponente verbaut ist, bei der die Wärmebehandlung eine vorgegebene Maximaltemperatur nicht übersteigen darf, um das Bauteil nicht zu schädigen. Ein weiteres Beispiel ist ein Ort, der für die niedrigste sich am oder im Bauteil einstellende Temperatur steht, was z.B. durch Vorab-Simulationen der Wärmebehandlung des Bauteils ermittelbar ist. Ein solcher Ort kann beispielsweise in der Regelung während der Durchführung des erfindungsgemäßen Verfahrens derart berücksichtigt werden, dass die sich einstellende Temperatur stets oberhalb eines vorgegebenen Minimalwertes liegt, damit z.B. eine vollständige Aushärtung einer Beschichtung auf dem Bauteil gewährleistet ist.

Die Auswahl von sich einstellenden Bauteiltemperaturen als Sollwerte kann auf den jeweiligen Anwendungsfall angepasst werden, wobei der Kombination von mehreren ausgewählten Bauteiltemperaturen auf denselben oder verschiedenen Bauteilen keine Grenzen gesetzt sind.

Die Berücksichtigung von mehreren Bauteiltemperaturen an unterschiedlichen Stellen in der Wärmekammer ermöglicht eine umfängliche Erfassung des sich im Betrieb bei der Durchströmung der Wärmekammer mit dem Heißgas an den Bauteilen einstellenden Temperaturprofils und eine detaillierte Modellbildung, auf Basis dessen eine noch gezieltere Regelung des Verfahrens der Wärmebehandlung durchgeführt werden kann.

Die sich einstellende Bauteiltemperatur wird durch ein in der Steuereinheit implementiertes prädiktives Modell bestimmt. Der Begriff "prädiktiv" ist synonym zu dem Begriff "vorausschauend" und impliziert, dass das Modell so eingerichtet ist, dass es zukünftige Zustände und/oder Zeitverläufe berechnen kann.

Da sich diese Bauteiltemperatur nicht unmittelbar über Sensoren messen lässt, ist das prädiktive Modell so konfiguriert, dass sich die Bauteiltemperatur aus zur Verfügung stehenden Daten, insbesondere aus den eingelesenen Messwerten bestimmen lässt. Zur Berechnung der nicht unmittelbar messbaren Bauteiltemperatur können Modelle verwendet werden, wie sie in der Regelungstechnik auch unter dem Begriff "Beobachter" bekannt sind (https://de.wikipedia.org/wiki/Beobachter_(Regelungstechnik)). Entsprechende Algorithmen und Entwurfsverfahren sind im Stand der Technik bekannt.

Neben den ermittelten Messwerten für Temperatur und gegebenenfalls Mengenstrom des Heißgases können auch weitere Einflussfaktoren bei der Berechnung der sich einstellenden Bauteiltemperatur oder bei der Berechnung der Stellgrößen berücksichtigt werden.

In einer Ausführungsform wird zur Bestimmung der sich einstellenden Bauteiltemperatur durch das Modell mindestens eine der folgenden Größen verwendet:
- eine Materialeigenschaft der Innenwände der Wärmekammer, insbesondere die Wärmekapazität der Innenwände der Wärmekammer,
- eine Materialeigenschaft des Bauteils, insbesondere die Wärmekapazität des Bauteils,
- Eigenschaften des Heißgases.

Die zu berücksichtigenden Größen können auf unterschiedliche Weise zur Verfügung gestellt werden. Ähnlich wie bei den Sollwerten können die Größen über Mittel zum Einlesen der Steuereinheit zur Verfügung gestellt werden. Die Größen können beispielsweise von einer Bedienperson eingegeben werden, z.B. über eine Tastatur, ein Bedienpanel, ein beschreibbares Display oder ein Mikrofon zur Eingabe von Sprachbefehlen. Die Parameter können auch aus einer anderen Anwendung bereitgestellt und über eine Kommunikationsschnittstelle an die Steuereinheit übermittelt werden, beispielsweise in Anwendungen, bei denen die Steuereinheit Teil eines weitergehenden Automatisierungssystems ist. Ähnlich wie beim Einlesen der Sollwerte können die zu berücksichtigenden Größen auch mittels eines Identifikationsmerkmals für die zu behandelnden Bauteile oder für eine Lagervorrichtung, die zu behandelnde Bauteile beinhaltet, das von einer Eingabeeinheit eingelesen wird, aus einer Produktdatenbank ausgelesen werden.

In einer Ausführungsform ist das prädiktive Modell auf Basis eines künstlichen neuronalen Netzes implementiert. Zum Training des neuronalen Netzes und der daraus resultierenden Anpassung der Parameter des prädiktiven Modells werden vorzugsweise mehrere Szenarien von unterschiedlichen Temperaturverläufen für die jeweils zu behandelnden Bauteilen verwendet. Vorzugsweise werden für die Trainingsphase ausgewählte Bauteile mit zusätzlichen Temperatursensoren versehen, während des Ablaufs der Wärmebehandlung Messwerte aufgezeichnet und anschließend die Parameter des prädiktiven Modells angepasst, beispielsweise durch Regressionsmethoden.

In einer Ausführungsform werden für den Vergleich gemäß dem zweiten Verfahrensschritt und die Bereitstellung der Stellsignale gemäß dem dritten Verfahrensschritt in einem geschlossenen Regelkreis die eingelesenen Messwerte einer Prädiktionseinheit zugeführt, in der Prädiktionseinheit die zu erwartende Bauteiltemperatur berechnet, aus dem Vergleich der vorgegebenen Sollwerte einerseits und den eingelesenen Messwerten und der berechneten Bauteiltemperatur andererseits eine Regelabweichung berechnet, und die Regelabweichung einem Regler zugeführt, der daraus auf Basis eines vorgegebenen Regelungsalgorithmus die Stellsignale für die Einstellung der Temperatur und/oder der Menge des Heißgasstromes berechnet.

### Kurzbeschreibung der Zeichnungen

Weitere vorteilhafte Ausgestaltungen werden nachfolgend anhand mehrerer in den Zeichnungen dargestellten Ausführungsbeispielen, auf welche die Erfindung jedoch nicht beschränkt ist, näher beschrieben. Die Zeichnungen sind als Prinzip-Darstellungen zu verstehen. Sie stellen keine Beschränkung der Erfindung dar, beispielsweise im Hinblick auf konkrete Abmessungen oder Ausgestaltungsvarianten, sofern sich aus der Beschreibung der Zeichnungen nichts Gegenteiliges ergibt.

Es zeigen:
- Figur 1: eine schematische Darstellung einer ersten Ausführungsform einer erfindungsgemäßen Vorrichtung im Längsschnitt;
- Figur 2: eine teilweise freigeschnittene perspektivische Ansicht einer Variante der ersten Ausführungsform gemäß Figur 1;
- Figur 3: eine Detailansicht der in Figur 2 dargestellten Ausführungsform;
- Figur 4: eine schematische Darstellung eines Regelkreises zur Verwendung in einer erfindungsgemäßen Vorrichtung;
- Figur 5: den zeitlichen Verlauf von Temperaturen während eines Aufheizvorgangs;
- Figur 6: eine schematische Darstellung einer zweiten Ausführungsform einer erfindungsgemäßen Vorrichtung in Queransicht.

### Detaillierte Beschreibung von Ausführungen der Erfindung

Bei der nachfolgenden Beschreibung von bevorzugten Ausführungsformen der vorliegenden Erfindung bezeichnen gleiche Bezugszeichen gleiche oder vergleichbare Komponenten. Bei mehreren gleichen Komponenten ist in der Regel nur eine mit einem Bezugszeichen versehen.

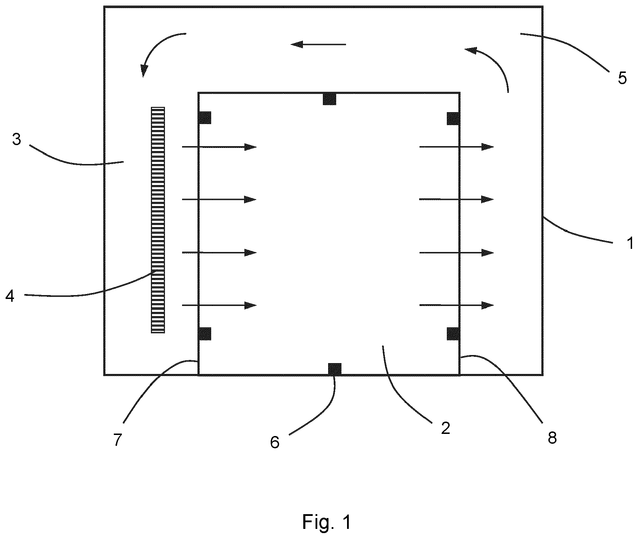

In Figur 1 ist schematisch eine erste Ausführungsform einer erfindungsgemäßen Vorrichtung zur Wärmebehandlung von Bauteilen im Längsschnitt dargestellt. Die in Figur 1 dargestellte Vorrichtung umfasst eine Wärmekammer 2, die als Quader mit zwei Seitenwänden, einer Rückwand, einer Vorderseite, einem Boden und einer Decke ausgebildet ist. Die - aufgrund des Längsschnittes nicht dargestellte - Vorderseite umfasst eine verschließbare Öffnung, durch die zu behandelnde Bauteile in die Wärmekammer 2 eingeführt und wieder aus ihr entnommen werden können.

In der Wärmekammer 2 sind mehrere örtlich verteilte Temperatursensoren 6 vorhanden, die in dem dargestellten Beispiel an beiden Seitenwänden, am Boden und an der Decke angeordnet sind. In dem in Figur 1 gezeigten Längsschnitt sind insgesamt sechs Temperatursensoren 6 dargestellt. Die Wärmekammer 2 kann jedoch auch weniger oder deutlich mehr Temperatursensoren 6 umfassen, die an unterschiedlichen Positionen in der Wärmekammer 2 angebracht sein können.

Die Wärmekammer 2 wird in dem dargestellten Beispiel von links nach rechts von einem Heißgas durchströmt, dessen Strömung in Figur 1 durch Pfeile dargestellt ist. Das Heißgas tritt durch Eintrittsöffnungen in der linken Seitenwand 7 in die Wärmekammer 2 ein und verlässt diese durch Austrittsöffnungen in der gegenüberliegenden Seitenwand 8.

Die Wärmekammer 2 ist in einem Gehäuse 1 angeordnet, das die Wärmekammer umhüllt. Zwischen den äußeren Oberflächen der Seitenwände sowie der Decke der Wärmekammer 2 und den jeweils benachbarten inneren Oberflächen des Gehäuses 1 ist ein Abstand vorhanden, wodurch sich ein Strömungsraum für das Heißgas um die Wärmekammer 2 ergibt. Der in Figur 1 links dargestellte Teil des Strömungsraumes ist als Heizkammer 3 ausgebildet, in der sich ein Heizelement 4 zur Erwärmung des Heißgases befindet. Im dargestellten Beispiel ist das Heizelement 4 ein sich in vertikaler Richtung und in Richtung senkrecht zur Zeichenebene erstreckendes flaches Element, das Öffnungen aufweist, durch die das abgekühlte Gas aus dem oberen Teil des Strömungskanals strömen kann, um aufgeheizt zu werden. Das Heizelement 4 kann beispielsweise elektrisch beheizt sein.

Die Vorrichtung zur Wärmebehandlung umfasst weiterhin - in Figur 1 nicht dargestellte - Mittel zur Erzeugung der Strömung des Heizgasstromes, beispielsweise ein Gebläse oder ein Ventilator, der vorzugsweise im Strömungsraum angeordnet ist. Über eine Variation der Leistung des Gebläses oder Ventilators sowie des Heizelements 4 kann der in die Wärmekammer 2 eingebrachte Heißgasstrom in Bezug auf seinen Mengenstrom und/oder seine Temperatur eingestellt werden.

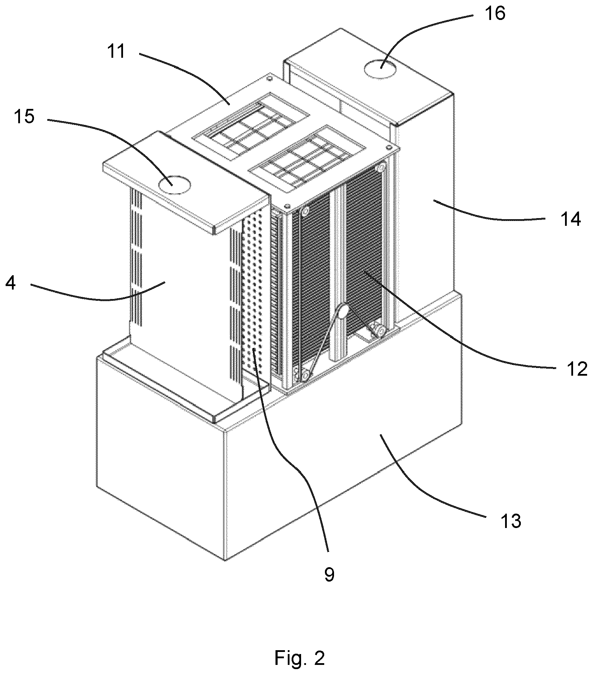

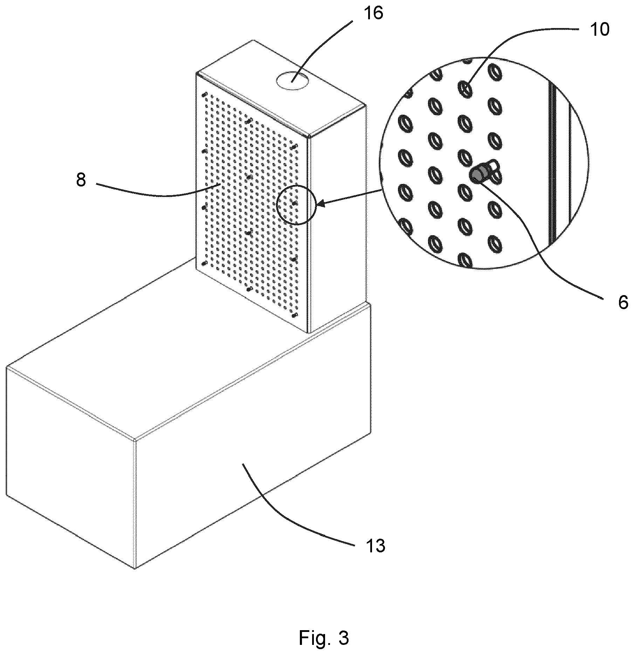

Das in Figur 1 dargestellte Strömungsprinzip kann auf unterschiedliche Weise verwirklicht werden, beispielsweise in einer Variante, wie sie in den Figuren 2 und 3 in teilweise freigeschnittener perspektivischer Ansicht dargestellt ist.

In dieser beispielhaften Ausführungsform ist die Lagervorrichtung 11 ein in die Wärmekammer 2 einbringbares und aus dieser entnehmbares Magazin. Die zu behandelnden Bauteile 12 sind in vertikaler Richtung übereinander und voneinander beabstandet in der Lagervorrichtung 11 gelagert. Bei den Bauteilen 12 kann es sich beispielsweise um elektronische Bauteile, insbesondere um Leiterplatten oder Platinen, handeln.

Bei der in Figur 2 dargestellten Ausführungsform umfasst das Gehäuse einen Sockel 13, auf dem links und rechts der Wärmekammer Seitenteile 14 aufgebaut sind. Das in Figur 2 freigeschnittene linke Seitenteil weist neben dem Heizelement 4 eine der Wärmekammer zugewandte Seitenwand 7 mit Eintrittsöffnungen 9 für das Heißgas auf. Das gegenüberliegende Seitenteil 14 weist eine der Wärmekammer zugewandte Seitenwand 8 mit Austrittsöffnungen 10 für das Heißgas auf. Die beiden Seitenteile 14 weisen an ihrem oberen Ende eine Zuströmöffnung 15 beziehungsweise eine Abströmöffnung 16 für das Heißgas auf. Der in Figur 2 nicht dargestellte obere Teil des Strömungsraums verbindet die beiden Öffnungen 15, 16, sodass das Heißgas in einem Kreislauf strömt.

Die Seitenwände 8, 9 weisen jeweils eine Vielzahl an Eintrittsöffnungen 9 beziehungsweise Austrittsöffnungen 10 auf, die in der jeweiligen Seitenwand gleichmäßig verteilt angeordnet sind. In dem in den Figuren 2 und 3 dargestellten Beispiel wird die gleichmäßige Verteilung durch ein regelmäßiges rechteckiges Gittermuster gebildet.

Um ein möglichst gutes Abbild der Temperatur des in die Wärmekammer einströmenden und diese verlassenden Heißgases zu erhalten, sind in der Ausführungsform gemäß Figur 2 und 3 mehrere Temperatursensoren 6 in räumlicher Nähe zu den Eintrittsöffnungen 9 und zu den Austrittsöffnungen 10 angeordnet. In dem in Figur 3 gezeigten Beispiel sind an der mit Austrittsöffnungen 10 versehenen Seitenwand 8 zwölf Temperatursensoren 6 in einem regelmäßigen rechteckigen Gitter an der Seitenwand angebracht und ragen von der Seitenwand in die Wärmekammer.

Die in den Figuren 1 bis 3 dargestellten Ausführungsformen umfassen weiterhin eine nicht abgebildete Steuereinheit, die beispielsweise als Mikrocontroller realisiert sein kann. Die Steuereinheit liest Messwerte für die Temperatur von den in der Wärmekammer 2 angeordneten Temperatursensoren 6 ein. In einer Variante der dargestellten Ausführungsform liest die Steuereinheit weiterhin Messwerte der Menge des Heißgasstromes ein, beispielsweise von einem Gebläse oder Ventilator.

In der Steuereinheit sind Sollwerte vorgegeben, mit denen die eingelesenen Messwerte verglichen werden. Die Vorgabe der Sollwerte kann beispielsweise über eine Kommunikationsschnittstelle erfolgen, sodass ein Bediener oder eine technische Einrichtung Sollwerte an die Steuereinheit übergeben kann. Als Sollwerte können beispielsweise zeitliche Verläufe der Temperatur und gegebenenfalls des Mengenstromes des Heißgases vorgegeben werden. Weiterhin wird als Sollwert eine sich bei mindestens einem der Bauteile einstellende Soll-Bauteiltemperatur vorgegeben. Da sich die Bauteiltemperatur nicht unmittelbar über Sensoren messen lässt, ist in der Steuereinheit ein prädiktives Modell implementiert, das so konfiguriert ist, dass sich die Bauteiltemperatur aus zur Verfügung stehenden Daten, insbesondere aus den eingelesenen Messwerten bestimmen lässt.

Auf Basis des Vergleichs zwischen vorgegebenen Sollwerten und eingelesenen und/oder berechneten Istwerten berechnet die Steuereinheit Stellsignale für die beeinflussbaren Zustände der Vorrichtung. Im dargestellten Beispiel können dies die Leistung des Gebläses oder die Drehzahl des Ventilators sowie die Heizleistung des Heizelements 4 sein.

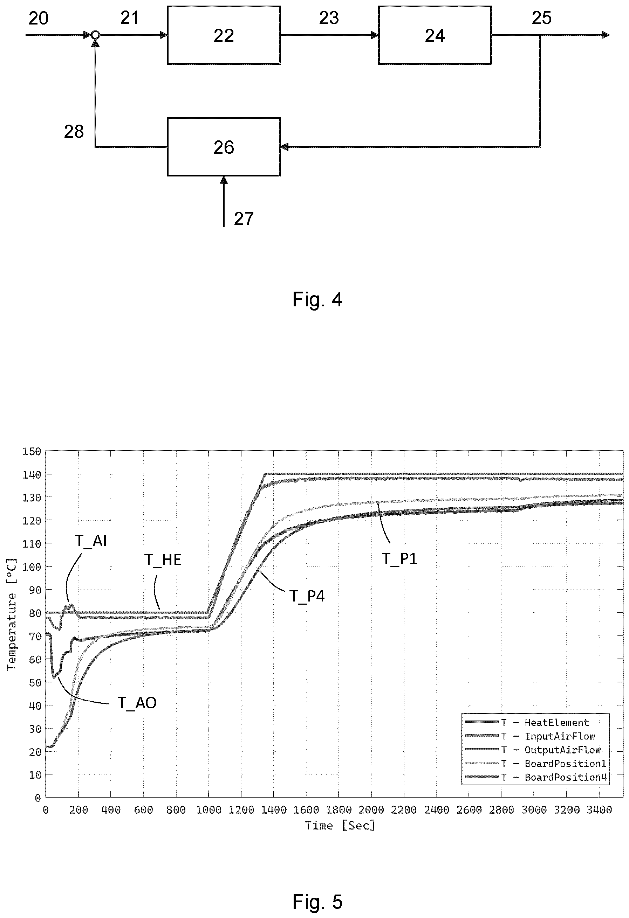

Figur 4 zeigt in einer schematischen Darstellung einen Regelkreis, der zur Verwendung in einer Ausführungsform gemäß der Figuren 1 bis 3 geeignet ist. Der Regelkreis umfasst in der Darstellung als Blockschaltbild die erfindungsgemäße Vorrichtung, die auch als "Anlage" 24 bezeichnet wird, einen Regler 22 sowie eine Prädiktionseinheit 26. Der Regler 22 und die Prädiktionseinheit 26 sind in der Steuereinheit implementiert.

Messwerte 25 für die Temperatur und gegebenenfalls den Mengenstrom des Heißgases aus der Anlage 24 werden erfasst und an die Prädiktionseinheit 26 übermittelt. In der Prädiktionseinheit 26 ist das prädiktive Modell implementiert, das auf Basis der Messwerte 25 mindestens eine zu erwartende Bauteiltemperatur berechnet. Wie im allgemeinen Teil oben beschrieben kann in dem erfindungsgemäßen Verfahren auch eine Vielzahl an Bauteiltemperaturen berücksichtigt werden, die insbesondere räumlich in vertikaler Richtung als auch in Strömungsrichtung des Heißgasstromes örtlich verteilt angeordnet sein können.

Bei der Berechnung können auch Anlagenparameter 27 berücksichtigt werden, die bereits im Modell implementiert sein können oder über eine Kommunikationsschnittstelle an die Steuereinheit übergeben werden können. Zur Berechnung geeignete Anlagenparameter 27 sind beispielsweise Wärmekapazitäten der Innenwände der Wärmekammer oder der zu behandelnden Bauteile, die einen Einfluss auf den zeitlichen Verlauf der Bauteiltemperatur haben, insbesondere in Phasen, in denen sich die Solltemperatur ändert. Wird beispielsweise die Solltemperatur erhöht, wird ein Teil der durch das Heißgas in den Innenraum eingebrachten Wärmemenge von den Innenwänden der Wärmekammer aufgenommen, die sich dadurch erwärmen. Es steht also zunächst weniger Wärme zur Aufheizung der Bauteile zur Verfügung, bis sich die Temperatur der Innenwände auf einen stationären Wert eingestellt hat. Umgekehrt strahlen bei einer Senkung der Solltemperatur die Innenwände der Wärmekammer noch eine gewisse Zeit Wärme ab, und es wird weniger Wärme durch das eingebrachte Heißgas benötigt, bis sich auch in diesem Fall die Temperatur der Innenwände auf einen stationären Wert eingestellt hat.

Zur Berechnung der nicht unmittelbar messbaren Bauteiltemperatur können Modelle verwendet werden, wie sie in der Regelungstechnik auch unter dem Begriff "Beobachter" bekannt sind (https://de.wikipedia.org/wiki/Beobachter (Regelungstechnik)). Als Ausgang stellt die Prädiktionseinheit 26 neben der berechneten Bauteiltemperatur auch Werte der Temperatur in der Wärmekammer und gegebenenfalls des Mengenstromes bereit. Diese Werte können den eingelesenen Messwerten entsprechen oder zur Nutzung im Regler manipuliert worden sein, beispielsweise gefiltert oder geglättet, um z.B. messtechnisch bedingte Ausreißer zu eliminieren. Der Datenstrom, der als Ausgang der Prädiktionseinheit 26 erhalten wird, wird auch als "Zustandsvektor" oder "Zustandsgrößen" 28 bezeichnet.

Die Zustandsgrößen 28, die die - originalen oder verarbeiteten - eingelesenen Messwerte und die berechnete Bauteiltemperatur umfassen, werden mit den vorgegebenen Sollwerten 20 verglichen. Auf Basis des Vergleichs wird eine sogenannte Regelabweichung 21 berechnet, die als Eingang an den Regler 22 übermittelt wird. Der Regler 22 berechnet auf Basis eines vorgegebenen Regelungsalgorithmus aus der Regelabweichung 21 Stellsignale 23 für die Einstellung der Temperatur und/oder der Menge des Heißgasstromes in der Anlage 24. Der Regelungsalgorithmus kann auf die jeweiligen Anforderungen des konkreten Anwendungsfalles angepasst sein, entsprechende Vorgehensweisen zum Entwurf und zur Implementierung eines Regelungsalgorithmus sind bekannt (https://de.wikipedia.org/wiki/Regelungstechnik#Regelkreisentwurf).

In einem Ausführungsbeispiel wurde in der Prädiktionseinheit 26 ein Modell erstellt, das aus den Temperaturen des Heißgasstromes am Eintritt in die Wärmekammer und am Austritt aus der Wärmekammer sowie der Menge des in die Wärmekammer eingetragenen Heißgases auf einem Bauteil zu erwartende Bauteiltemperaturen berechnet. Die der Wärmebehandlung zu unterziehenden Bauteile waren in diesem Beispiel beschichtete Leiterplatten (PCBs), bei denen durch Temperatureinwirkung die Beschichtung aushärtet. Als Heißgas wurde Luft eingesetzt.

Zur Berechnung der zu erwartenden Bauteiltemperaturen und dem damit einhergehenden zeitlichen Verlauf des Aushärteprozesses wurde ein parametriertes Modell erstellt, das die Abmessungen, das Volumen und die spezifische Wärmekapazität der Bauteile berücksichtigt. Die entsprechenden Modellparameter wurden durch Fuzzy-Regression anhand realer Daten ermittelt. Beispielhaft sind in Figur 5 zeitliche Verläufe von Temperaturen während eines Aufheizvorgangs in einer Wärmekammer dargestellt, die zur Modellbildung mittels Regression verwendet werden können.

Die einzelnen Temperaturverläufe zeigen die Temperatur (T_HE) des Heizelements, die Temperatur (T_AI) in der Wärmekammer an den Eintrittsöffnungen des heißen Luftstroms, die Temperatur (T_AO) in der Wärmekammer an den Austrittsöffnungen des Luftstroms, die Temperatur (T_P1) an einer Stelle auf dem Bauteil, die dem Lufteintritt zugewandt ist, und die Temperatur (T_P4) an einer Stelle auf dem Bauteil, die dem Luftaustritt zugewandt ist. Zur Bestimmung der Temperatur auf dem Bauteil wurde dieses an mehreren Stellen in Richtung des Luftstromes verteilt mit Thermoelementen versehen.

Das Heizelement wurde auf eine Temperatur von 80°C vorgeheizt. Zum Zeitpunkt 20 sec (Sekunden) wurde die Tür der Wärmekammer geöffnet, und die Bauteile in die Wärmekammer eingebracht. Wie aus den Verläufen in Figur 5 ersichtlich, sank dabei die Temperatur in der Wärmekammer signifikant ab. Zum Zeitpunkt 60 sec wurde die Tür geschlossen. Zum Zeitpunkt 100 sec wurde das Gebläse zur Förderung des durch das Heizelement erhitzten Luftstromes eingeschaltet. Die Menge des Luftstroms wurde nicht unmittelbar gemessen, sondern aus der Drehzahl des Gebläses abgeleitet. Zum Zeitpunkt 150 sec wurde die Frequenz des Gebläses von 4 Hz auf 8 Hz erhöht. Wie Figur 5 zu entnehmen ist, stieg die Temperatur der Bauteile rasch an und erreichte bis zum Zeitpunkt 1000 sec einen annähernd stationären Zustand von ca. 70°C auf den Bauteilen. Zu diesem Zeitpunkt wurde sowohl die Frequenz des Gebläses auf 30 Hz gesteigert, als auch die Heizleistung des Heizelements in Form einer Rampe erhöht, bis das Heizelement zum Zeitpunkt 1330 sec eine Temperatur von 140°C erreichte. Zum Zeitpunkt 2500 sec wurde die Drehzahl des Gebläses erneut erhöht auf eine Frequenz von 50 Hz. Die gemessenen Temperaturverläufe wurden zur Modellerstellung verwendet, das anhand weiterer, nicht zum Training des Modells verwendeter Daten erfolgreich validiert werden konnte.

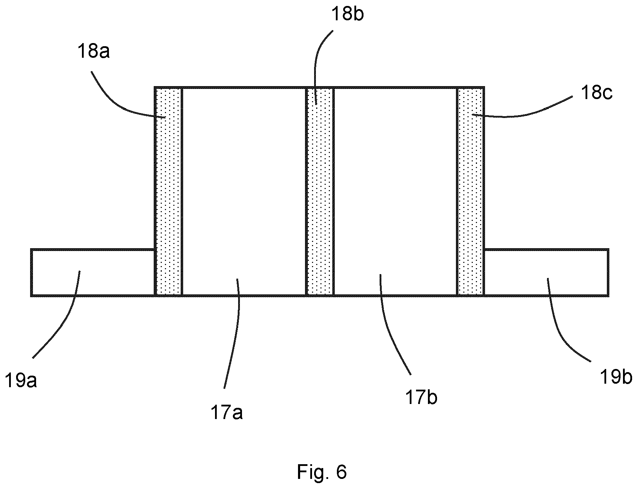

In Figur 6 ist schematisch eine zweite Ausführungsform einer erfindungsgemäßen Vorrichtung zur Wärmebehandlung von Bauteilen in Queransicht dargestellt. Die in Figur 6 dargestellte Vorrichtung ist modular aufgebaut und umfasst zwei Heizmodule 17, drei Trennmodule 18 und zwei Transportmodule 19.

Die beiden Heizmodule 17a, 17b umfassen jeweils eine Wärmekammer und innerhalb der Wärmekammer angeordnete Temperatursensoren. In einer ersten Variante umfassen beide Heizmodule jeweils auch Mittel zur Erzeugung eines Heißgasstromes, beispielsweise ein Gebläse oder Ventilator sowie ein Heizelement. In dieser Variante können die Heizmodule 17 beispielsweise ähnlich der oben erläuterten ersten Ausführungsform ausgebildet sein. In einer zweiten Variante umfasst nur eines der beiden Heizmodule 17 Mittel zur Erzeugung eines Heißgasstromes. In dem dargestellten Beispiel sind die Innenräume der Wärmekammern beider Heizmodule 17 in zwei Raumrichtungen offen. In dem dargestellten Beispiel sind jeweils die gegenüberliegenden Seiten der beiden Heizmodule 17 offen.

Die drei Trennmodule 18 sind in dem dargestellten Beispiel gleich ausgeführt und umfassen jeweils einen Rahmen mit einer Durchgangsöffnung und ein in dem Rahmen beweglich gelagertes Verschlusselement, das im offenen Zustand die Durchgangsöffnung freigibt und im geschlossenen Zustand die Durchgangsöffnung vollständig verschließt. Das mittlere Trennmodul 18b ist derart mit einer der offenen Seite des ersten Heizmoduls 17a und einer der offenen Seiten des zweiten Heizmoduls 17b verbunden ist, dass im offenen Zustand der Durchgangsöffnung eine gemeinsame Wärmekammer vorliegt, die von den beiden Innenräumen der Heizmodule 17a, 17b und der geöffneten Durchgangsöffnung des Trennmoduls 18b gebildet wird. Im geschlossenen Zustand des Verschlusselements liegen mit den Innenräumen der Heizmodule 17a und 17b zwei voneinander getrennte Wärmekammern vor. Im letzteren Fall bietet es sich an, dass beide Heizmodule 17a, 17b über Mittel zur Erzeugung eines Heißgasstromes verfügen, damit beide Heizmodule unabhängig voneinander betrieben werden können. Im ersteren Fall der gemeinsamen Wärmekammer genügt es, wenn eines der Heizmodule 17a, 17b über Mittel zur Erzeugung eines Heißgasstromes verfügt.

Das Trennmodul 18a ist mit der anderen offenen Seite des ersten Heizmoduls 17a derart verbunden, dass die Durchgangsöffnung des Trennmoduls 18a die verschließbare Öffnung der Wärmekammer des ersten Heizmoduls 17a bildet. Analog ist das Trennmodul 18c mit der anderen offenen Seite des zweiten Heizmoduls 17b derart verbunden, dass die Durchgangsöffnung des Trennmoduls 18c die verschließbare Öffnung der Wärmekammer des zweiten Heizmoduls 17b bildet.

Auf jeder Seite der Vorrichtung ist jeweils ein Transportmodul 19a, 19b angeordnet, das ausgebildet ist, eine Lagervorrichtung durch das jeweilige geöffnete Trennmodul 18a bzw. 18c in die jeweilige Wärmekammer einzubringen. Bei der Lagervorrichtung kann es sich beispielsweise um ein Magazin handeln, wie es in Bezug auf die erste Ausführungsform in Figur 2 beschrieben ist. In dem Magazin können die zu behandelnden Bauteile in vertikaler Richtung übereinander und voneinander beabstandet gelagert sein. Bei den Bauteilen kann es sich beispielsweise um elektronische Bauteile, insbesondere um Leiterplatten oder Platinen, handeln.

Ein Vorteil dieser Ausführungsform mit modularem Aufbau ist es, dass sie flexibel auf die jeweiligen Bedürfnisse der konkret zur realisierenden Wärmebehandlung anpassbar ist. So kann beispielsweise bei einer großen Stückzahl an zu behandelnden gleichartigen Bauteilen das mittlere Trennmodul 18b geöffnet werden, sodass eine große gemeinsame Wärmekammer zur Verfügung steht, in der die gleichen Bedingungen für die Wärmebehandlung herrschen. Für eine andere Anwendung, bei unterschiedliche Bauteile bei unterschiedlichen Bedingungen behandelt werden sollen, kann das mittlere Trennmodul 18b geschlossen werden, sodass zwei separat zur betreibende Wärmekammern zur Verfügung stehen. In einem weiteren Anwendungsfall, bei dem Bauteile zunächst über einen ersten Zeitraum bei ersten Bedingungen und anschließend über einen zweiten Zeitraum bei zweiten Bedingungen behandelt werden sollen, kann beispielsweise eine entsprechend mit Bauteilen bestückte Lagervorrichtung zunächst über das Transportmodul 19a in die Wärmekammer des ersten Heizmoduls 18a eingebracht werden und dort über den ersten Zeitraum behandelt werden. Anschließend kann das mittlere Trennmodul 18b geöffnet und die Lagervorrichtung in die zweite Wärmekammer des zweiten Heizmoduls 18b eingebracht und dort nach Schließen des mittleren Trennmoduls 18b über den zweiten Zeitraum behandelt werden. Währenddessen steht die Wärmekammer wieder zur Verfügung und kann beispielsweise erneut für Wärmebehandlung zu den ersten Bedingungen oder auch zu anderen Bedingungen genutzt werden.

Es versteht sich von selbst, dass die Ausführungsform mit modularem Aufbau nicht auf die schematisch in Figur 6 dargestellte Bauform beschränkt ist, sondern beliebig um Heizmodule 17, Trennmodule 18 und Transportmodule 19 erweitert bzw. abgeändert werden kann. Die Steuerung der einzelnen Wärmebehandlungsvorgänge kann zentral über eine gemeinsame Steuereinheit oder dezentral über separate, den jeweiligen Modulen zugeordnete Steuereinheiten erfolgen.

Die in der vorstehenden Beschreibung, den Ansprüchen und den Zeichnungen offenbarten Merkmale können sowohl einzeln als auch in beliebiger Kombination für die Verwirklichung der Erfindung in ihren verschiedenen Ausführungsformen von Bedeutung sein.

### Bezugszeichenliste

- 1: Gehäuse
- 2: Wärmekammer
- 3: Heizkammer
- 4: Heizelement
- 5: Strömungskanal
- 6: Temperatursensor
- 7: Seitenwand mit Eintrittsöffnungen
- 8: Seitenwand mit Austrittsöffnungen
- 9: Eintrittsöffnungen
- 10: Austrittsöffnungen
- 11: Lagervorrichtung
- 12: Bauteil
- 13: Sockel
- 14: Seitenteil
- 15: Zuströmöffnung
- 16: Abströmöffnung
- 17: Heizmodul
- 18: Trennmodul
- 19: Transportmodul
- 20: Sollwerte
- 21: Regelabweichung
- 22: Regler
- 23: Stellsignale
- 24: Anlage
- 25: Messwerte
- 26: Prädiktionseinheit
- 27: Anlagenparameter
- 28: Zustandsgrößen

## Patentansprüche

1. Verfahren zur Wärmebehandlung von Bauteilen (12) in einer verschließbaren Wärmekammer (2), wobei die Bauteile (12) vertikal voneinander beabstandet in einer Lagervorrichtung (11) innerhalb der Wärmekammer (2) gelagert sind und von einem hinsichtlich seiner Temperatur und/oder seiner Menge einstellbaren Heißgasstrom umströmt werden, das Verfahren umfassend die in einer Steuereinheit durchgeführten Schritte:
(i) Einlesen von Messwerten für Temperaturen von mehreren in der Wärmekammer (2) örtlich verteilten Temperatursensoren (6) und optional der Menge des Heißgasstromes;
(ii) Vergleich der eingelesenen Messwerte mit vorgegebenen Sollwerten; und
(iii) Bereitstellung von Stellsignalen für die Einstellung der Temperatur und/oder der Menge des Heißgasstromes in Abhängigkeit des Vergleichs derart, dass ein vorgegebener zeitlicher Verlauf für die Sollwerte während der Wärmebehandlung eingehalten wird,
**dadurch gekennzeichnet, dass** die Sollwerte eine sich bei mindestens einem der Bauteile (12) einstellende Soll-Bauteiltemperatur umfassen, wobei die sich einstellende Bauteiltemperatur durch ein in der Steuereinheit implementiertes prädiktives Modell bestimmt wird.

2. Verfahren nach Anspruch 1, **dadurch gekennzeichnet, dass** die Sollwerte sich einstellende Soll-Bauteiltemperaturen von mindestens zwei unterschiedlichen Bauteilen (12) umfassen, von denen eines in der oberen Hälfte der Lagervorrichtung (11) und das andere in der unteren Hälfte der Lagervorrichtung (11) gelagert ist.

3. Verfahren nach Anspruch 1 oder 2, **dadurch gekennzeichnet, dass** die Sollwerte mindestens zwei sich bei demselben Bauteil (12) einstellende Soll-Bauteiltemperaturen umfassen, wobei die Orte, an denen sich die Bauteiltemperaturen einstellen, in Strömungsrichtung des Heißgasstromes einen Abstand aufweisen.

4. Verfahren nach einem der vorhergehenden Ansprüche, **dadurch gekennzeichnet, dass** zur Bestimmung der sich einstellenden Bauteiltemperatur durch das Modell mindestens eine der folgenden Größen verwendet wird:
- eine Materialeigenschaft der Innenwände der Wärmekammer (2), insbesondere die Wärmekapazität der Innenwände der Wärmekammer (2),
- eine Materialeigenschaft des Bauteils (12), insbesondere die Wärmekapazität des Bauteils (12),
- Eigenschaften des Heißgases.

5. Verfahren nach einem der vorhergehenden Ansprüche, **dadurch gekennzeichnet, dass** für den Vergleich gemäß Schritt (ii) und die Bereitstellung der Stellsignale gemäß Schritt (iii) in einem geschlossenen Regelkreis die eingelesenen Messwerte einer Prädiktionseinheit zugeführt werden, in der Prädiktionseinheit die zu erwartende Bauteiltemperatur berechnet wird, aus dem Vergleich der vorgegebenen Sollwerte einerseits und den eingelesenen Messwerten und der berechneten Bauteiltemperatur andererseits eine Regelabweichung berechnet wird, und die Regelabweichung einem Regler zugeführt wird, der daraus auf Basis eines vorgegebenen Regelungsalgorithmus die Stellsignale für die Einstellung der Temperatur und/oder der Menge des Heißgasstromes berechnet.

6. Verfahren nach einem der vorhergehenden Ansprüche, **dadurch gekennzeichnet, dass** die Lagervorrichtung (11) ein in die Wärmekammer (2) einbringbares und aus dieser entnehmbares Magazin ist.

7. Verfahren nach einem der vorhergehenden Ansprüche, **dadurch gekennzeichnet, dass** die Bauteile (12) flächige Bauteile, bevorzugt elektronische Bauteile, insbesondere Leiterplatten oder Platinen sind.

8. Verfahren nach einem der vorhergehenden Ansprüche, **dadurch gekennzeichnet, dass** der Heißgasstrom durch Eintrittsöffnungen (9) in einer Seitenwand (7) der Wärmekammer (2) in die Wärmekammer eintritt und durch Austrittsöffnungen (10) in der gegenüberliegenden Seitenwand (8) die Wärmekammer (2) wieder verlässt.

9. Verfahren nach Anspruch 8, **dadurch gekennzeichnet, dass** eine Vielzahl an Eintrittsöffnungen (9) und/oder Austrittsöffnungen (10) in der jeweiligen Seitenwand gleichmäßig verteilt angeordnet ist.

10. Verfahren nach Anspruch 8 oder 9, **dadurch gekennzeichnet, dass** zumindest einige der Temperatursensoren (6) in räumlicher Nähe zu den Eintrittsöffnungen (9) und einige der Temperatursensoren (6) in räumlicher Nähe zu den Austrittsöffnungen (10) angeordnet sind.

11. Vorrichtung zur Wärmebehandlung von Bauteilen (12) umfassend eine verschließbare Wärmekammer (2), die mehrere örtlich verteilte Temperatursensoren (6) aufweist, Mittel zur Erzeugung eines hinsichtlich seiner Temperatur und/oder seiner Menge einstellbaren Heißgasstromes, sowie eine Steuereinheit, die so eingerichtet ist, dass sie die Schritte des Verfahrens nach einem der Ansprüche 1 bis 10 ausführt.

12. Vorrichtung nach Anspruch 11, **dadurch gekennzeichnet, dass** die Vorrichtung modular aufgebaut ist und mindestens ein Heizmodul (17) und ein Trennmodul (18) aufweist, wobei das Heizmodul (17) den Innenraum der Wärmekammer (2), die darin angeordneten Temperatursensoren (6) sowie die Mittel zur Erzeugung des Heißgasstromes umfasst, wobei der Innenraum der Wärmekammer (2) zumindest in eine Raumrichtung offen ist, das Trennmodul (18) einen Rahmen mit einer Durchgangsöffnung und ein in dem Rahmen beweglich gelagertes Verschlusselement, das im offenen Zustand die Durchgangsöffnung freigibt und im geschlossenen Zustand die Durchgangsöffnung vollständig verschließt, umfasst, und das Trennmodul (18) derart mit der offenen Seite des Heizmoduls (17) verbunden ist, dass die Durchgangsöffnung des Trennmoduls (18) die verschließbare Öffnung der Wärmekammer (2) bildet.

13. Vorrichtung nach Anspruch 11, **dadurch gekennzeichnet, dass** die Vorrichtung modular aufgebaut ist und mindestens ein erstes Heizmodul (17b), ein zweites Heizmodul (17a) und zwei Trennmodule (18a, 18b) aufweist, wobei die beiden Heizmodule (17a, 17b) jeweils den Innenraum der Wärmekammer (2) und die darin angeordneten Temperatursensoren (6) umfassen, und mindestens eines der Heizmodule (17a, 17b) die Mittel zur Erzeugung des Heißgasstromes umfasst, wobei der Innenraum der Wärmekammer (2) des ersten Heizmoduls (17b) zumindest in eine Raumrichtung offen ist, der Innenraum der Wärmekammer (2) des zweiten Heizmoduls (17a) in zwei Raumrichtungen offen ist, die Trennmodule (18a, 18b) einen Rahmen mit einer Durchgangsöffnung und ein in dem Rahmen beweglich gelagertes Verschlusselement, das im offenen Zustand die Durchgangsöffnung freigibt und im geschlossenen Zustand die Durchgangsöffnung vollständig verschließt, umfassen, ein Trennmodul (18b) derart mit der offenen Seite des ersten Heizmoduls (17b) und einer offenen Seite des zweiten Heizmoduls (17a) verbunden ist, dass im offenen Zustand der Durchgangsöffnung eine gemeinsame Wärmekammer (2) und im geschlossenen Zustand zwei separate Wärmekammern (2) vorliegen, und das andere Trennmodul (18a) derart mit der anderen offenen Seite des zweiten Heizmoduls (17a) verbunden ist, dass die Durchgangsöffnung des Trennmoduls (18a) die verschließbare Öffnung der Wärmekammer (2) bildet.

14. Computerprogrammprodukt, umfassend Befehle, die bei der Ausführung des Programms durch die Steuereinheit der Vorrichtung nach Anspruch 11 bis 13 diese veranlassen, das Verfahren nach Anspruch 1 bis 10 auszuführen.

15. Computerlesbares Medium, auf dem das Computerprogrammprodukt nach Anspruch 14 gespeichert ist.
